# FASCICULE DE BREVET EUROPEEN

(11) **EP 0 951 067 B1**
(45) Date de publication et mention de la délivrance du brevet: **01.08.2018**
(21) Numéro de dépôt: 99400744.1
(22) Date de dépôt: 26.03.1999
(51) Int. Cl.: H01L 21/768

(54) **Circuit intégré avec couche d'arrêt et procédé de fabrication associé**
Integrierte Schaltung mit einer Ätz-Stoppschicht und Herstellungsverfahren
Integrated circuit with etch stop layer and method of fabrication

(30) Priorité: 16.04.1998 FR 9804754
(43) Date de publication de la demande: 20.10.1999
(73) Titulaire: STMicroelectronics S.A., 92120 Montrouge (FR)
(72) Inventeur: Verove, Christophe, 38400 Saint Martin d'Heres (FR)
(74) Mandataire: Casalonga, Axel

(56) Documents cités:
- EP-A- 0 463 956
- EP-A- 0 680 085
- WO-A-96/12297
- DE-A- 19 610 272
- US-A- 5 736 457
- R. D. TACITO ET AL.: "Fine-line patterning of parylene-n by reactive ion etching for application as an interlayer dielectric" JOURNAL OF THE ELECTROCHEMICAL SOCIETY., vol. 143, no. 6, juin 1996, pages 1974-1977, XP002087806 MANCHESTER, NEW HAMPSHIRE US
- PRICE D T ET AL: "Damascene copper interconnects with polymer ILDs" THIN SOLID FILMS, vol. 308-309, no. 1-4, 31 octobre 1997, page 523-528 XP004110329

## Description

La présente invention concerne le domaine des circuits intégrés à semi-conducteurs, comprenant un empilement de couches conductrices séparées par des couches isolantes et leur procédé de fabrication. Le document WO9612297 décrit une structure d'interconnexion comprenant deux niveaux de couches conductrices. Dans de tels circuits intégrés, il est nécessaire d'établir des connexions électriques entre des couches métallisées conductrices de niveaux différents et par conséquent séparées par une ou plusieurs couches isolantes.

De façon connue, deux couches conductrices sont connectées électriquement au moyen de trous prévus dans la couche isolante et remplis de métal, une telle connexion étant appelée "Via".

De tels circuits intégrés peuvent être réalisés selon un procédé appelé "Damascène", dans lequel on dépose une première couche isolante sur une couche de métallisation de niveau n. On effectue la gravure des trous à travers cette couche isolante, on dépose le métal constituant le via et on le polit jusqu'au niveau de la surface supérieure de la couche isolante, puis on dépose une nouvelle couche isolante sur le via de niveau n ainsi constitué, on effectue la gravure des tranchées constituant les futures lignes, on dépose le métal constituant les lignes de la couche de métallisation de niveau n+1, puis on polit le métal jusqu'au niveau de la surface supérieure de la couche isolante, etc.

Ce procédé est bien adapté à la réalisation de lignes et de vias en cuivre, ce matériau ne pouvant être gravé à température ambiante et présentant des caractéristiques électriques intéressantes pour les lignes de faible largeur. Ce procédé peut aussi être utilisé avec les métaux constituant habituellement les lignes et les vias.

Dans le procédé "double damascène", le métal est déposé à la fois dans les vias et les lignes, puis poli. Une couche d'arrêt, habituellement en nitrure, est prévue entre une couche isolante du niveau n et le niveau de métallisation n+1. L'obtention de la structure finale nécessite une excellente sélectivité de la gravure de l'oxyde constituant la couche isolante par rapport au nitrure.

Pour augmenter la densité d'un circuit intégré, on cherche à réduire la largeur des lignes de métal et la largeur du matériau diélectrique séparant deux lignes de métal. Or, la capacité électrique existant entre deux lignes de métal adjacentes est inversement proportionnelle à la distance les séparant. En réduisant cette distance pour augmenter la densité du circuit, on augmente la capacité entre lignes, ce qui est gênant car cela se traduit par une augmentation de la constante de propagation du signal électrique dans les lignes τ = RC (R : résistance de la ligne métal; C : capacité interlignes), ainsi que par une augmentation du couplage parasite entre deux signaux électriques se propageant dans deux lignes adjacentes (effet de "cross talk"). Or, cette capacité entre lignes est proportionnelle au coefficient de permittivité "k" du matériau diélectrique utilisé. On tend donc à utiliser des matériaux diélectriques à faible coefficient de permittivité "k".

A cet effet, on peut utiliser des polymères organiques diélectriques qui présentent des coefficients de permittivité réduits de plus de 30% par rapport à l'oxyde de silicium SiO₂ utilisé habituellement. Toutefois, ces polymères organiques posent de difficiles problèmes lors de la gravure en raison de leur composition chimique proche de celle du masque de résine utilisé pour la photogravure des tranchées. Le retrait du masque de résine s'effectue par une gravure isotrope dans laquelle les ions effectuant la gravure sont en mouvement dans toutes les directions, ce qui peut provoquer l'altération, voire la gravure du polymère organique servant de diélectrique. Un inconvénient similaire résulte de l'utilisation d'un diélectrique réalisé à partir d'un polymère minéral à la surface duquel se produit une altération qui dégrade localement le coefficient de permittivité.

La présente invention a pour objet de remédier aux inconvénients des techniques évoquées ci-dessus.

La présente invention a pour objet un procédé de fabrication de circuit intégré du type damascène avec diélectrique à faible coefficient de permittivité.

Le procédé de fabrication d'un circuit intégré, selon l'invention, est défini par l'objet de la revendication 1. Il comprend les étapes suivantes :
- sur une couche diélectrique en polymère organique ou minéral recouvrant un niveau de métallisation n incluant des lignes de métallisation séparées par un matériau diélectrique, on dépose une première et une deuxième couches d'arrêt, et un masque de résine sur la deuxième couche d'arrêt,
- on effectue la gravure de la deuxième couche d'arrêt sélectivement par rapport à la première couche d'arrêt, seules les portions de la deuxième couche d'arrêt non recouvertes par le masque étant gravées, et on retire le masque de résine,
- on effectue la gravure de la première couche d'arrêt sélectivement par rapport à la couche diélectrique, seules les portions de la première couche d'arrêt non recouvertes par la deuxième couche d'arrêt étant gravées,
- on dépose une couche diélectrique supplémentaire sur le circuit,
- on effectue la gravure de la couche diélectrique supplémentaire et de la couche diélectrique sélectivement par rapport aux couches d'arrêt, provoquant ainsi la formation de tranchées dans la couche diélectrique supplémentaire et de trous dans la couche diélectrique.

On peut ainsi utiliser un diélectrique en polymère organique ou minéral à faible coefficient de permittivité sans risque de dégradation de celui-ci, ce qui permet d'obtenir des capacités entre lignes de valeur faible.

Ultérieurement, on peut déposer du métal dans les trous et dans les tranchées pour former respectivement des vias connectant les lignes des niveaux de métallisation n et n+1, et les lignes du niveau de métallisation n+1. Une étape de polissage du métal constituant les lignes du niveau de métallisation n+1 peut également être prévue.

Dans un mode de réalisation de l'invention, on dispose une couche d'encapsulation autour des lignes de métal, cette couche d'encapsulation peut être réalisée en nitrure de silicium et s'avère utile lorsqu'on utilise pour les lignes un métal qui risque de diffuser autour de la ligne dans le diélectrique. Une telle diffusion de métal, notamment de cuivre ou d'or dans le diélectrique, se traduirait par une diminution de l'isolation électrique entre les lignes. Le risque majeur est que la contamination métallique (Cu ou Au) atteigne le substrat de silicium, créant des niveaux d'énergie profonds dans la bande interdite du semiconducteur, et augmentant la résistivité du substrat. On dépose une troisième couche d'arrêt sur la couche diélectrique supplémentaire, et un masque de résine sur la troisième couche d'arrêt et on effectue la gravure de la troisième couche d'arrêt sélectivement par rapport à la couche diélectrique supplémentaire, seules les portions de la troisième couche d'arrêt non recouvertes par le masque étant gravées, la gravure des couches diélectriques provoquant le retrait simultané du masque de résine.

La présente invention a également pour objet un circuit intégré dans lequel la couche diélectrique est susceptible d'être altérée par le procédé de gravure utilisé pour le retrait du masque de résine servant à la photogravure des emplacements des lignes de métallisation.

Le circuit intégré, selon l'invention, comprend au moins deux niveaux de métallisation n et n+1 incluant chacun des lignes de métallisation séparées par un matériau diélectrique en polymère organique ou minéral, une couche diélectrique disposée entre les deux niveaux de métallisation et traversée par des vias assurant une connexion électrique entre des lignes des niveaux de métallisation, et une première couche d'arrêt disposée entre la couche diélectrique et le niveau de métallisation n+1 et apte à être gravée sélectivement par rapport à la couche diélectrique.

Le circuit intégré comprend une deuxième couche d'arrêt disposée sur la première couche d'arrêt et apte à être gravée sélectivement par rapport à la première couche d'arrêt. Avantageusement, une troisième couche d'arrêt est disposée sur le niveau de métallisation n+1 et apte à être gravée sélectivement par rapport au matériau diélectrique du niveau de métallisation n+1. En effet, le masque utilisé pour la photogravure est de nature proche des polymères à faible coefficient de permittivité que l'on souhaite utiliser, notamment des polymères organiques, et qui seraient altérés lors du retrait du masque.

Dans un mode de réalisation de l'invention, les lignes de métallisation sont réalisées en cuivre. Elles pourraient également être réalisées en or.

Avantageusement, la couche diélectrique est réalisée en polymère organique à coefficient de permittivité électrique inférieur à 3, par exemple en polymère SILK, de coefficient K = 2,6.

Dans un mode de réalisation de l'invention, le matériau diélectrique des niveaux de métallisation est identique à celui de la couche diélectrique. Il peut en être de même pour la couche diélectrique supplémentaire.

Dans un mode de réalisation de l'invention, la première couche d'arrêt est réalisée en nitrure de silicium.

Dans un autre mode de réalisation de l'invention, la première couche d'arrêt est réalisée en oxynitrure de silicium.

Dans un autre mode de réalisation de l'invention, la deuxième couche d'arrêt est réalisée en oxyde de silicum.

De préférence, on utilisera les combinaisons suivantes : première couche d'arrêt en nitrure de silicium et deuxième couche d'arrêt en oxyde de silicium ou première couche d'arrêt en nitrure de silicium et deuxième couche d'arrêt en oxynitrure de silicium, ou encore première couche d'arrêt en oxynitrure de silicium et deuxième couche d'arrêt en oxyde de silicium. La troisième couche d'arrêt peut être réalisée dans l'un de ces trois matériaux.

Ainsi, on dispose d'un circuit intégré qui peut être réalisé avec des largeurs de lignes et des largeurs de matériau diélectrique entre lignes très faibles en raison de l'utilisation d'un diélectrique à faible coefficient de permittivité et qui n'est pas dégradé lors de la fabrication du circuit selon le procédé damascène.

La présente invention sera mieux comprise à l'étude de la description détaillée d'un mode de réalisation pris à titre nullement limitatif et illustré par les dessins annexés, sur lesquels :
les figures la à 1g illustrent les étapes d'un procédé double damascène selon l'art antérieur ;
les figures 2a à 2c illustrent les étapes d'un procédé double damascène avec diélectrique en polymère organique, selon l'art antérieur; et
les figures 3a à 3h montrent les étapes du procédé de fabrication selon l'invention.

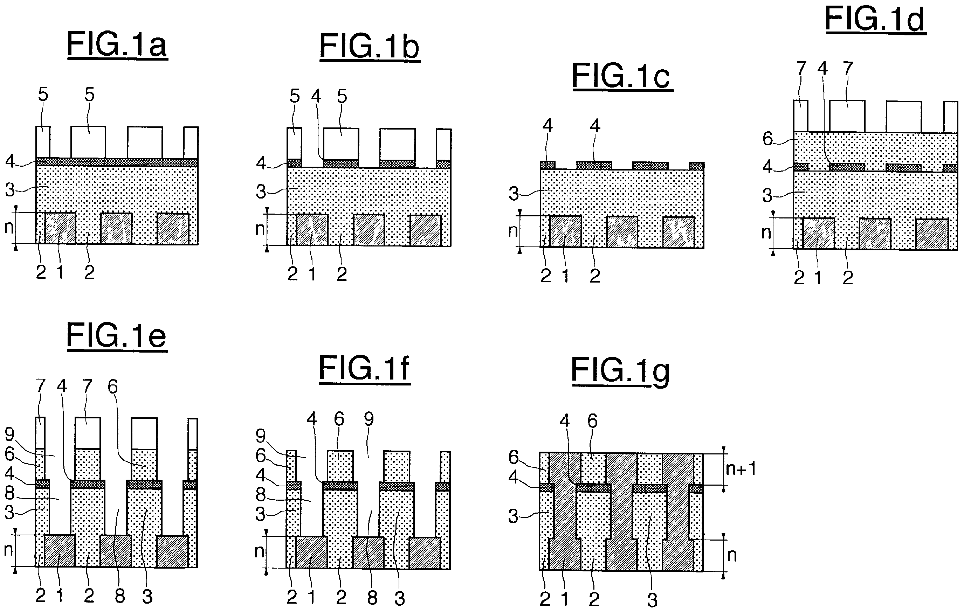

Comme on peut le voir sur la figure 1a, le circuit intégré, représenté en coupe, comprend des lignes de métal 1 séparées par un matériau diélectrique 2, qui constituent un niveau de métallisation n. Ce niveau de métallisation n est recouvert d'une couche diélectrique 3, par exemple en oxyde de silicium de coefficient de permittivité de l'ordre de 4, de même nature que le matériau diélectrique 2. Cette couche diélectrique 3 est recouverte par une couche d'arrêt 4 dont la composition chimique sera légèrement différente de façon à pouvoir être gravée sélectivement par rapport à la couche diélectrique 3. La couche d'arrêt 4 est recouverte partiellement par un masque 5 servant à la photogravure.

Sur la figure 1b, on a effectué la gravure de la couche d'arrêt 4 sélectivement par rapport à la couche diélectrique 3 et au masque 5. On procède ensuite à l'enlèvement du masque 5 (figure 1c), ce qui n'a aucune influence sur la couche diélectrique 3 en raison de sa composition différente de celle du masque 5.

Sur la figure 1d, on a recouvert le circuit de matériau diélectrique 6 et d'un masque 7. On effectue ensuite la gravure du matériau diélectrique 6 et de la couche diélectrique 3 sélectivement par rapport au masque 7 et à la couche d'arrêt 4. On définit ainsi des trous 8 traversant la couche diélectrique 3 et des tranchées 9 traversant le matériau diélectrique 6 (figure 1e).

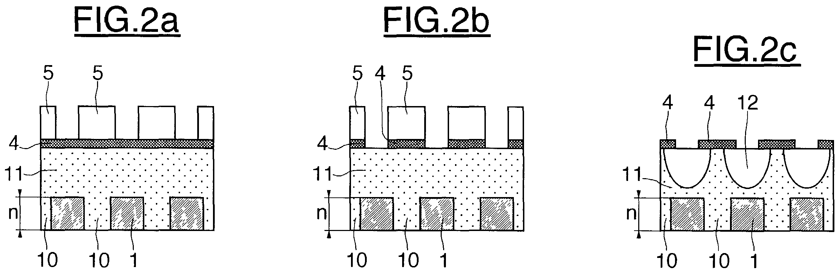

Sur la figure 1f, on procède à l'enlèvement du masque 7 sélectivement par rapport au matériau diélectrique 6 et à la couche diélectrique 3, de la même façon que pour le masque 5. On vient ensuite, voir figure 1g, remplir les trous 8 et les tranchées 9 de métal, les trous 8 remplis de métal constituant des vias entre des niveaux de métallisation n et n+1 et les tranchées 9 remplies de métal constituant les lignes du niveau de métallisation n+1. Ce procédé n'est pas adapté à la fabrication de circuits comprenant des matériaux diélectriques à faible coefficient de permittivité comme il sera expliqué pour la figure 2.

Les figures 2a à 2c représentent les mêmes étapes que les figures la à 1c, mais avec des matériaux diélectriques différents. Le matériau diélectrique 10 séparant les lignes de métallisation 1, et la couche diélectrique 11 sont réalisés tous deux à partir d'un diélectrique à faible coefficient de permittivité de type polymère organique. La couche d'arrêt 4 est prévue pour pouvoir être gravée sélectivement par rapport à la couche diélectrique 11.

Comme on peut le voir sur la figure 2c, le procédé utilisé pour l'enlèvement du masque 5 n'est pas sélectif par rapport à la couche diélectrique 11, ce qui se traduit par la formation de trous 12 de forme absolument non maîtrisée, le procédé de gravure utilisé pour le retrait du masque 5 étant de type isotrope et attaquant la matière dans toutes les directions. Si du métal était déposé ensuite dans de tels trous 12, cela se traduirait par une isolation électrique peu satisfaisante, une capacité importante entre de tels vias, ce qui conduirait à un circuit intégré dont les caractéristiques seraient inacceptables.

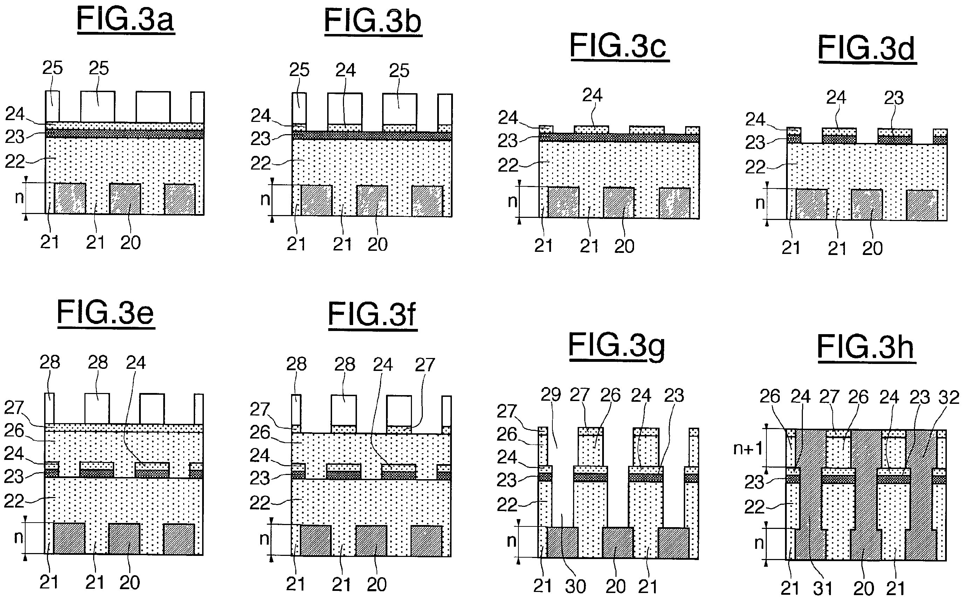

La figure 3 montre les différentes étapes du procédé conforme à l'invention, qui permet d'utiliser un diélectrique à faible coefficient de permittivité du type minéral ou organique dans un procédé damascène.

Comme on peut le voir sur la figure 3a, le circuit intégré comprend un niveau de métallisation n constitué de lignes métallisées 20, par exemple en cuivre, séparées par un diélectrique 21. Le niveau de métallisation n est recouvert par une couche diélectrique 22 réalisée avec le même matériau à faible coefficient de permittivité que le diélectrique 21, par exemple de type minéral connu sous le nom de Fox, de coefficient de permittivité égal à 3, ou de type organique connu sous le nom de Silk, de coefficient de permittivité égal à 2,6, ce dernier étant préférable car il peut être utilisé en couches épaisses, par exemple 2 µm contrairement au diélectrique minéral limité à 0,7 µm. Cet inconvénient s'ajoute à celui de présenter un coefficient de permittivité légèrement plus élevé.

La couche diélectrique 22 est recouverte d'une première couche d'arrêt 23 et d'une seconde couche d'arrêt 24. La première couche d'arrêt 23 est de composition telle qu'elle puisse être gravée sélectivement par rapport à la couche diélectrique 22. Il en est de même de la deuxième couche d'arrêt 24 qui doit pouvoir être gravée sélectivement par rapport à la première couche d'arrêt 23. La deuxième couche d'arrêt 24 est recouverte d'un masque 25 pour la photogravure.

A l'étape suivante, voir figure 3b, on effectue la gravure de la deuxième couche d'arrêt 24 sélectivement par rapport au masque 25 et à la première couche d'arrêt 23. Seules les parties de la deuxième couche d'arrêt 24 non recouvertes par le masque 25, sont retirées en raison de leur exposition au procédé de gravure. Puis on procède au retrait du masque 25, voir figure 3c, qui peut être retiré sélectivement par rapport à la deuxième couche d'arrêt 24 et à la première couche d'arrêt 23 au moyen d'un plasma riche en oxygène. A cette étape, la couche diélectrique 22 est entièrement protégée par la première couche d'arrêt 23.

Ensuite, voir figure 3d, on procède à la gravure de la première couche d'arrêt 23 sélectivement par rapport à la deuxième couche d'arrêt 24 et à la couche diélectrique 22.

Comme on peut le voir sur la figure 3e, on procède au dépôt d'une couche diélectrique supplémentaire 26 sur le circuit intégré. Cette couche diélectrique supplémentaire 26 peut être réalisée dans le même matériau que la couche diélectrique 22. La couche diélectrique supplémentaire 26 est ensuite recouverte d'une troisième couche d'arrêt 27 apte à être gravée sélectivement par rapport à la couche diélectrique supplémentaire 26 et d'un masque 28 destiné à la photogravure.

On effectue la gravure de la troisième couche d'arrêt 27 sélectivement par rapport au masque 28 et à la couche diélectrique supplémentaire 26, voir figure 3f, seules les parties de la troisième couche d'arrêt 27 qui sont protégées par le masque 28 restant en place, les autres étant retirées par la gravure.

Comme on peut le voir sur la figure 3g, on effectue la gravure de la couche diélectrique supplémentaire 26 et de la couche diélectrique 22 de façon sélective par rapport à la troisième couche d'arrêt 27 et à la deuxième couche d'arrêt 24, ce qui provoque la formation de tranchées 29 au niveau de la couche diélectrique supplémentaire 26, et de trous 30 au niveau de la couche diélectrique 22 et des première et deuxième couches d'arrêt 23 et 24. Comme cette opération de gravure doit être sélective par rapport aux troisième et deuxième couches d'arrêt 27 et 24, on peut prévoir de réaliser celles-ci dans le même matériau, par exemple en oxyde de silicium SiO₂ ou en oxynitrure de silicium SiON. Dans le premier cas, on pourra prévoir une première couche d'arrêt en oxynitrure de silicium SiON ou en nitrure de silicium SiN. Dans le second cas, on pourra prévoir une première couche d'arrêt en nitrure de silicium. On pourrait également utiliser des première et seconde couches d'arrêt dont la composition est inversée par rapport à ce qui vient d'être exposé, ou encore une troisième couche d'arrêt de composition différente de celle de la deuxième.

On préfèrera utiliser une couche de nitrure de silicium de faible épaisseur, par exemple 200 à 300 Å, en raison de son fort coefficient de permittivité. Une couche d'oxyde de silicium peut être plus épaisse, par exemple 1000 Å, car ce matériau est de permittivité plus satisfaisante. Une couche en oxynitrure SiON peut être mise en oeuvre de façon avantageuse en raison de ses caractéristiques antiréflectives qui permettent d'éviter un changement de la taille des trous lors de la photogravure. On peut optimiser l'épaisseur de cette couche par rapport à la longueur d'onde de la lumière utilisée pour éviter l'attaque du masque sur les bords des trous.

Après la gravure des tranchées 29 et des trous 30, on effectue leur remplissage de métal pour former des vias 31 dans les trous 30 et des lignes 32 dans les tranchées 29, formant ainsi le niveau de métallisation n+1. On peut ensuite réitérer le procédé pour obtenir un circuit intégré comprenant plus de deux niveaux de métallisation.

On voit donc que la couche diélectrique 22 est protégée lors du retrait du masque 25 par la présence de deux couches d'arrêt dont la deuxième a fait l'objet d'une gravure permettant le marquage des emplacements futurs des vias. Lors de la gravure des tranchées 29 et des trous 30, le circuit intégré est polarisé électriquement de façon que la trajectoire des ions effectuant la gravure soit verticale pour attaquer la matière selon la seule direction verticale et effectuer ainsi une gravure anisotrope. Pendant cette étape de gravure, le masque 28 disposé sur une troisième couche d'arrêt 27 est rapidement consommé par les ions du plasma qui arrivent sur la surface du circuit intégré aux endroits où se trouve le masque 28. L'opération de retrait du masque 28 et de gravure des tranchées 29 et des trous 30, est donc effectuée simultanément. Mais cette gravure anisotrope n'affecte pas les portions de la couche diélectrique 22 ou de la couche diélectrique supplémentaire 26 protégées par les différentes couches d'arrêt, ce qui permet d'obtenir des tranchées 29 et des trous 30 de forme convenable conservant une épaisseur sensiblement constante de matériau diélectrique entre eux.

Grâce à l'invention, on dispose d'un procédé de fabrication de type damascène d'un circuit intégré comprenant des couches diélectriques à faible coefficient de permittivité, ce qui permet de réaliser des lignes et des vias en cuivre avec des largeurs de gravure faibles, d'où une augmentation de la densité d'intégration du circuit intégré.

## Revendications

1. Procédé de fabrication d'un circuit intégré, **caractérisé par le fait que** :
- sur une couche diélectrique (22) en polymère organique ou minéral recouvrant un niveau de métallisation n incluant des lignes de métallisation (20) séparées par un matériau diélectrique (21), on dépose une première (23) et une deuxième (24) couches d'arrêt, et un masque de résine (25) sur la deuxième couche d'arrêt,
- on effectue la gravure de la deuxième couche d'arrêt (24) sélectivement par rapport à la première couche d'arrêt (23), seules les portions de la deuxième couche d'arrêt non recouvertes par le masque étant gravées, et on retire le masque de résine,
- on effectue la gravure de la première couche d'arrêt (23) sélectivement par rapport à la couche diélectrique (22), seules les portions de la première couche d'arrêt non recouvertes par la deuxième couche d'arrêt étant gravées,
- on dépose une couche diélectrique supplémentaire (26) sur le circuit, une troisième couche d'arrêt (27) sur la couche diélectrique supplémentaire (26), et un masque de résine (28) sur la troisième couche d'arrêt,
- on effectue la gravure de la troisième couche d'arrêt (27) sélectivement par rapport à la couche diélectrique supplémentaire (26), seules les portions de la troisième couche d'arrêt non recouvertes par le masque étant gravées,
- on effectue la gravure de la couche diélectrique supplémentaire et de la couche diélectrique sélectivement par rapport aux couches d'arrêt, provoquant ainsi la formation de tranchées dans la couche diélectrique supplémentaire et de trous dans la couche diélectrique et le retrait du masque de résine (28).

2. Procédé selon la revendication 1, **caractérisé par le fait qu'**on dépose du métal dans les trous et dans les tranchées pour former respectivement des vias connectant les lignes des niveaux de métallisation n et n+1, et des lignes du niveau de métallisation n+1.

3. Procédé selon la revendication 1 ou 2, **caractérisé par le fait que** la couche diélectrique est réalisée en polymère organique à coefficient de permittivité électrique inférieur à 3.

4. Circuit intégré comprenant au moins deux niveaux de métallisation n et n+1 incluant chacun des lignes de métallisation séparées par un matériau diélectrique, une couche diélectrique (22) en polymère organique ou minéral disposée entre les deux niveaux de métallisation et traversée par des vias (31) assurant une connexion électrique entre des lignes des niveaux de métallisation, et une première couche d'arrêt (23) disposée entre la couche diélectrique et le niveau de métallisation n+1 et apte à être gravée sélectivement par rapport à la couche diélectrique, **caractérisé par le fait qu'**il comprend une deuxième couche d'arrêt (24) disposée sur la première couche d'arrêt et apte à être gravée sélectivement par rapport à la première couche d'arrêt (23).

5. Circuit selon la revendication 4, **caractérisé par le fait que** les lignes de métallisation sont réalisées en cuivre.

6. Circuit selon la revendication 4 ou 5, **caractérisé par le fait que** la couche diélectrique (22) est réalisée en polymère organique à coefficient de permittivité électrique inférieur à 3.

7. Circuit selon l'une quelconque des revendications 4 à 6, **caractérisé par le fait que** le matériau diélectrique des niveaux de métallisation est identique au matériau de la couche diélectrique (22).

8. Circuit selon l'une quelconque des revendications 4 à 7, **caractérisé par le fait que** la première couche d'arrêt (23) est réalisée en nitrure de silicium ou en oxynitrure de silicium, et que la deuxième couche d'arrêt (24) est réalisée en oxyde de silicium.

9. Circuit selon l'une quelconque des revendications 4 à 8, **caractérisé par le fait qu'**il comprend une troisième couche d'arrêt (27) disposée sur le niveau de métallisation n+1 et apte à être gravée sélectivement par rapport au matériau diélectrique du niveau de métallisation n+1.

## Patentansprüche

1. Herstellverfahren für einen integrierten Schaltkreis, **dadurch gekennzeichnet, dass**:
- auf einer eine Metallisierungsebene n umfassend durch ein dielektrisches Material (21) getrennte Metallisierungsleitungen (20) abdeckenden dielektrischen Schicht (22) aus organischem oder mineralischem Polymer eine erste (23) und eine zweite (24) Sperrschicht und eine Harzmaske (25) auf der zweiten Sperrschicht aufgebracht werden,
- das Ätzen der zweiten Sperrschicht (24) selektiv in Bezug auf die erste Sperrschicht (23) erfolgt, wobei ausschließlich die von der Maske nicht abgedeckten Teile der zweiten Sperrschicht geätzt werden, und die Harzmaske entfernt wird,
- das Ätzen der ersten Sperrschicht (23) selektiv in Bezug auf die dielektrische Schicht (22) erfolgt, wobei ausschließlich die von der zweiten Sperrschicht nicht abgedeckten Teile der ersten Sperrschicht geätzt werden,
- eine zusätzliche dielektrische Schicht (26), eine dritte Sperrschicht (27) auf der zusätzlichen dielektrischen Schicht (26) und eine Harzmaske (28) auf der dritten Sperrschicht aufgebracht werden,
- das Ätzen der dritten Sperrschicht (27) selektiv in Bezug auf die zusätzliche dielektrische Schicht (26) erfolgt, wobei ausschließlich die von der Maske nicht abgedeckten Teile der dritten Sperrschicht geätzt werden,
- das Ätzen der zusätzlichen dielektrischen Schicht und der dielektrischen Schicht selektiv in Bezug auf die Sperrschichten erfolgt, was die Bildung von Gräben in der zusätzlichen dielektrischen Schicht und von Löchern in der dielektrischen Schicht und das Entfernen der Harzmaske (28) bewirkt.

2. Verfahren nach Anspruch 1, **dadurch gekennzeichnet, dass** Metall in den Löchern und in den Gräben aufgebracht wird, um jeweils Verbindungslöcher zum Verbinden der Leitungen der Metallisierungsebenen n und n+1 und Leitungen der Metallisierungsebene n+1 zu bilden.

3. Verfahren nach Anspruch 1 oder 2, **dadurch gekennzeichnet, dass** die dielektrische Schicht aus organischem Polymer mit einem elektrischen Permittivitätskoeffizienten kleiner als 3 besteht.

4. Integrierter Schaltkreis umfassend wenigstens zwei Metallisierungsebenen n und n+1 umfassend jeweils durch ein dielektrisches Material getrennte Metallisierungsleitungen, eine zwischen den zwei Metallisierungsebenen angeordnete und von Verbindungslöchern (31) durchquerte dielektrische Schicht (22) aus organischem oder mineralischem Polymer zum Herstellen einer elektrischen Verbindung zwischen den Leitungen der Metallisierungsebenen, und eine zwischen der dielektrischen Schicht und der Metallisierungsebene n+1 angeordnete und zum selektiven Geätztwerden in Bezug auf die dielektrische Schicht ausgebildete erste Sperrschicht (23), **dadurch gekennzeichnet, dass** er eine auf der ersten Sperrschicht angeordnete und zum selektiven Geätztwerden in Bezug auf die erste Sperrschicht (23) ausgebildete zweite Sperrschicht (24) umfasst.

5. Schaltkreis nach Anspruch 4, **dadurch gekennzeichnet, dass** die Metallisierungsleitungen aus Kupfer bestehen.

6. Schaltkreis nach Anspruch 4 oder 5, **dadurch gekennzeichnet, dass** die dielektrische Schicht (22) aus organischem Polymer mit einem elektrischen Permittivitätskoeffizienten kleiner als 3 besteht.

7. Schaltkreis nach einem der Ansprüche 4 bis 6, **dadurch gekennzeichnet, dass** das dielektrische Material der Metallisierungsebenen identisch mit dem Material der dielektrischen Schicht (22) ist.

8. Schaltkreis nach einem der Ansprüche 4 bis 7, **dadurch gekennzeichnet, dass** die erste Sperrschicht (23) aus Siliciumnitrid oder Siliciumoxynitrid besteht und dass die zweite Sperrschicht (24) aus Siliciumoxid besteht.

9. Schaltkreis nach einem der Ansprüche 4 bis 8, **dadurch gekennzeichnet, dass** er eine auf der Metallisierungsebene n+1 angeordnete und zum selektiven Geätztwerden in Bezug zum dielektrischen Material der Metallisierungsebene n+1 ausgebildete dritte Sperrschicht (27) umfasst.

## Claims

1. Process for fabricating an integrated circuit, **characterized in that**:
- a first (23) and a second (24) stop layer are deposited on a dielectric layer (22) made of an organic or inorganic polymer covering a metallization level n, which includes metallization lines (20) separated by a dielectric material (21), and a resin mask (25) is deposited on the second stop layer;
- the second stop layer (24) is selectively etched with respect to the first stop layer (23), only those portions of the second stop layer which are not covered by the mask being etched, and the resin mask is removed;
- the first stop layer (23) is selectively etched with respect to the dielectric layer (22), only those portions of the first stop layer which are not covered by the second stop layer being etched;
- an additional dielectric layer (26) is deposited on the circuit, a third stop layer (27) is deposited on the additional dielectric layer (26) and a resin mask (28) is deposited on the third stop layer;
- the third stop layer (27) is selectively etched with respect to the additional dielectric layer (26), only those portions of the third stop layer which are not covered by the mask being etched; and
- the additional dielectric layer and the dielectric layer are selectively etched with respect to the stop layers, thus causing the formation of trenches in the additional dielectric layer and of holes in the dielectric layer and the removal of the resin mask (28) .

2. Process according to Claim 1, **characterized in that** metal is deposited in the holes and in the trenches in order to form vias connecting the lines of the metallization levels n and n+1, and lines of the metallization level n+1, respectively.

3. Process according to Claim 1 or 2, **characterized in that** the dielectric layer is made of an organic polymer having a electrical permittivity coefficient of less than 3.

4. Integrated circuit comprising at least two metallization levels n and n+1, each including metallization lines separated by a dielectric material, a dielectric layer made of an organic or inorganic polymer placed between the two metallization levels and penetrated by vias (31) ensuring electrical connection between lines of the metallization levels, and a first stop layer (23) placed between the dielectric layer and the metallization level n+1 and capable of being selectively etched with respect to the dielectric layer, **characterized in that** it comprises a second stop layer (24) placed on the first stop layer and capable of being selectively etched with respect to the first stop layer (23)

5. Circuit according to Claim 4, **characterized in that** the metallization lines are made of copper.

6. Circuit according to Claim 4 or 5, **characterized in that** the dielectric layer (22) is made of an organic polymer having an electrical permittivity coefficient of less than 3.

7. Circuit according to any one of Claims 4 to 6, **characterized in that** the dielectric material of the metallization levels is identical to the material of the dielectric layer (22).

8. Circuit according to any one of Claims 4 to 7, **characterized in that** the first stop layer (23) is made of silicon nitride or of silicon oxynitride, and that the second stop layer (24) is made of silicon oxide.

9. Circuit according to any one of Claims 4 to 8, **characterized in that** it comprises a third stop layer (27) placed on the metallization level n+1 and capable of being selectively etched with respect to the dielectric material of the metallization level n+1.
